# EUROPEAN PATENT APPLICATION

(11) **EP 2 942 326 A1**
(43) Date of publication of application: **11.11.2015**
(21) Application number: 14166997.8
(22) Date of filing: 05.05.2014
(51) Int. Cl.: C01B 31/04

(54) **SUBSTRATE PRE-TREATMENT FOR CONSISTENT GRAPHENE GROWTH BY CHEMICAL DEPOSITION**

(71) Applicant: BASF SE, 67056 Ludwigshafen (DE); Max-Planck-Gesellschaft zur Förderung der Wissenschaften e.V. Berlin, 80539 München (DE)
(72) Inventor: Strudwick, Andrew-James, Manchester M15 4UW (GB); Schwab, Matthias Georg, 68199 Mannheim (DE); Müllen, Klaus, 50939 Köln (DE); Sachdev, Hermann, 66123 Saarbrücken (DE); Weber, Nils-Eike, 67098 Bad Dürkheim (DE); Binder, Axel, 76137 Karlsruhe (DE)
(74) Representative: Maiwald Patentanwalts GmbH

(57) **Abstract**

The present invention relates to a process for preparing graphene, comprising
(i) providing in a chemical deposition chamber a substrate which has a surface S1,
(ii) subjecting the substrate to a thermal pre-treatment while feeding at least one gaseous or supercritical oxidant into the chemical deposition chamber so as to bring the surface S1 into contact with the at least one gaseous or supercritical oxidant and obtain a pre-treated surface S2,
(iii) preparing graphene on the pre-treated surface S2 by chemical deposition.

## Description

The present invention relates to a pre-treatment of substrates for improving consistency of graphene grown by chemical deposition.

Graphene is seen as an exciting material for a number of different applications such as transparent flexible conducting electrodes, gas sensing, and post CMOS electronic devices. For these applications, manufacturing methods are needed which are consistently producing large areas of graphene of sufficiently high quality.

A very promising, economically efficient and readily accessible approach for manufacturing graphene is chemical deposition, such as chemical vapour deposition (CVD), onto appropriate substrates such as metal substrates. See e.g. C. Mattevi, J. Mater. Chem., 2011, Vol. 21, pp. 3324-3334.

Typically, the substrate used for chemically depositing graphene is subjected to a thermal pre-treatment in a reducing atmosphere such as hydrogen for reducing an oxygen-containing surface layer that may have an adverse impact on process efficiency and/or graphene quality if still present during the chemical deposition step. A further effect aimed at by the thermal pre-treatment step is increasing the metal grain size.

R.S. Ruoff et al., J. Mater. Res., Vol. 29, 2014, pp. 403-409, found that some metal substrates may still have carbon deposits on their surfaces even when subjected to a long-term thermal annealing in a hydrogen atmosphere; and this residual pyrolytic carbon may adversely affect the chemical deposition of graphene. In the chemical deposition process described by R.S. Ruoff et al., a copper substrate is oxidized in air so as to obtain a copper-oxide-containing substrate which is then thermally treated in the chemical deposition chamber so as to re-establish the copper surface for subsequent graphene growth and oxidative removal of carbon deposits. As mentioned by Ruoff et al., oxidation of the starting metal foil has to be carefully controlled so as to avoid an excessively oxidized metal substrate which would then take a long time to be fully reduced to the elementary metal in the CVD chamber.

In the graphene growth step, a carbon-atom containing precursor compound (such as a saturated or unsaturated hydrocarbon compound) is brought into contact with the pre-treated substrate surface. Typically, during the chemical deposition step, the gas phase does not only contain a hydrocarbon compound but also hydrogen. For safety reasons, a hydrogen-free chemical deposition process would be very beneficial. However, the hydrogen-free synthesis of high quality graphene by chemical deposition (e.g. CVD) on substrates such as metal (e.g. Cu) foils or films still remains a challenge, in particular in the pressure range of 10⁻⁴ mbar to 1.5 bar.

S. Cho et al., ACS Nano, Vol. 8, No. 1, 2014, pp. 950-956, describe the preparation of graphene by hydrogen-free rapid thermal chemical vapour deposition.

In another approach for improving the graphene growth by chemical deposition, the substrate surface is re-structured. WO 2013/062264 describes the preparation of graphene by chemical deposition wherein a metal substrate having a specific crystallographic orientation is used and step structures are formed on the substrate surface.

With regard to process/product consistency and process flexibility, it is desirable that one and the same pre-treatment method is still efficient if a first substrate (for which the pre-treatment method has proven to be efficient) is replaced by another substrate having similar or comparable product specifications. Typically, graphene manufacturers are using substrates which are commercially available (e.g. metal foils or films) and are specified by the supplier by a limited set of parameters (e.g. metal purity, foil/film thickness, etc.). When replacing a first substrate by another substrate which is specified by the supplier by parameters corresponding to or at least being very similar (e.g. in terms of chemical composition, metal purity, foil/film thickness) to those of the first substrate, it would of course be desirable that the same graphene quality is achieved without modifying process parameters (such as substrate pre-treatment conditions, etc.).

It is an object of the present invention to enable graphene formation by a chemical deposition process leading to consistency in the product properties (e.g. in terms of product quality even if a substrate is used which has a high tendency of forming carbon deposits on its surface in a thermal annealing step). Furthermore, it would be desirable if such a process allowed improving safety aspects.

The object is solved by a process for preparing graphene, comprising
(i) providing in a chemical deposition chamber a substrate which has a surface S1,
(ii) subjecting the substrate to a thermal pre-treatment while feeding at least one gaseous or supercritical oxidant into the chemical deposition chamber so as to bring the surface S1 of the substrate into contact with the at least one gaseous or supercritical oxidant and obtain a pre-treated surface S2,
(iii) preparing graphene on the pre-treated surface S2 by chemical deposition.

In the present invention, it has surprisingly been realized that graphene quality can be improved by subjecting the substrate to a thermal pre-treatment while feeding a gaseous or supercritical oxidant into the chemical deposition chamber, thereby continuously maintaining an oxidizing atmosphere in the chemical deposition chamber during the thermal pre-treatment step. If a substrate is made of a material that would form pyrolytic carbon on its surface in a reducing/inert atmosphere, pre-treatment of said substrate in the oxidizing atmosphere is successfully preventing the formation of carbon deposits. In other words, as the substrate is contacted with the oxidizing atmosphere, the pyrolytic carbon deposits on the substrate surface may either not form at all or, if formed, are oxidatively removed during the pre-treatment step so as to have a clean surface for the chemical deposition step. No pre-oxidation of the metal substrate is required. Furthermore, it has surprisingly been realized that the quality of the graphene grown in a subsequent chemical deposition step is not only improved for those substrates that would form pyrolytic carbon but also for those substrates that would not form pyrolytic carbon.

With the term "pre-treatment" or "pre-treatment step", it is indicated that the substrate is subjected to a treatment in preparation of the chemical deposition step to be carried out afterwards.

In the present application, the term "graphene" is not limited to a single layer graphene but also encompasses a few-layer graphene having e.g. up to fifty graphene layers or up to twenty graphene layers or up to five graphene layers.

Substrates that can be used for chemical deposition of graphene are commonly known.

The substrate can be provided in any form or shape which is consistent with its use in a chemical deposition process. The substrate can be in the form of e.g. a foil, a film, a wafer, a mesh, a foam, a wire, a coil, a rod or any other suitable geometry.

The substrate can be a metal, an intermetallic compound (e.g. a metal silicide or a metal boride, Zintl phase materials), an inorganic oxide, a metal oxide (e.g. a main group or transition metal oxide), metal nitrides, a semi-conductor, an electrical insulator or any mixture or combination thereof.

The metal can be a transition metal (i.e. a metal from groups 3 to 12 of the Periodic Table), a rare earth metal, or a metal from groups 13 to 15 of the Periodic Table, or any mixture thereof. Preferably, the metal is Cu or Ni.

The metal can be an unalloyed metal (i.e. the metal does not contain an alloying element). Preferably, the metal does not contain a second metal acting as an alloying element. Alternatively, a metal alloy can be used as well.

If needed, the substrate (such as a metal film or metal foil, e.g. a Cu foil or film) can be subjected to a mechanical pre-treatment such as grinding, polishing or cold-rolling. Alternatively, in the present invention, it is possible that the substrate is not subjected to a mechanical pre-treatment such as cold-rolling. If subjected to cold-rolling, the reduction ratio can vary over a broad range. It can be less than 80%, or less than 70%, or even less than 50%. Alternatively, it can be 80% or higher.

The substrate (such as a metal substrate) can be polycrystalline (e.g. a polycrystalline metal foil or film). As commonly known to the skilled person, a polycrystalline material is a solid composed of crystallites of varying size and orientation. Alternatively, the substrate can be a single crystal substrate.

The metal (e.g. Cu) forming the substrate may contain oxygen. The metal (e.g. Cu) can have an oxygen content of less than 500 wt-ppm or less than 200 wt-ppm or less than 100 wt-ppm or even less than 10 wt-ppm. Alternatively, it is also possible to use a metal substrate having an oxygen content exceeding the values mentioned above.

The substrate can also be prepared by chemical vapor deposition, physical vapor deposition, sputtering techniques, vacuum evaporation, thermal evaporation, electron-beam evaporation, molecular-beam epitaxy, hydride vapour phase epitaxy, liquid phase epitaxy, atomic layer deposition, or combinations thereof.

Exemplary intermetallic compounds that may form the substrate include metal silicides, metal borides, metal dichalcogenides and Zintl phase materials of a defined chemical stoichiometry.

Exemplary inorganic oxides that may form the substrate include glass, quartz and ceramic substrates. Exemplary metal oxides that may be used as a substrate include aluminum oxide, sapphire, silicon oxide, zirconium oxide, indium tin oxide, hafnium dioxide, bismuth strontium calcium copper oxide (BSCCO), molybdenum oxides, tungsten oxides, Perovskite-type oxides. Exemplary semi-conductors include silicon, germanium , gallium arsenide, indium phosphide, silicon carbide, semiconducting dichalcogenides such as molybdenum sulfides and tungsten sulfides. Exemplary electrical insulators include boron nitride, micas and ceramics.

The substrate can be a substrate which forms carbon on its surface S1 if subjected to a thermal treatment in a hydrogen atmosphere (i.e. an atmosphere consisting of hydrogen), e.g. at a temperature of at least 300°C for 7 days or less (preferably at a hydrogen pressure of from 10⁻⁴ hPa to 10 hPa). The carbon formed by pyrolytic treatment in hydrogen can be any form of carbon or carbon-rich C-H-O compound or graphite, graphene, CNT or amorphous carbon, or a mixture thereof. The carbon can be detected e.g. by scanning electron microscopy and Raman spectroscopy.

The pyrolytic carbon may originate e.g. from any carbon-containing substance which is present on the surface S1 (such a carbon-containing compound in turn originating e.g. from the manufacturing process of the substrate, processing aids or impurities). Accordingly, the substrate can be a substrate which has one or more carbon-containing compounds on its surface S1. Exemplary carbon-containing substances that may be present on the surface S1 of the substrate include hydrocarbon compounds or heteroatom-containing hydrocarbon compounds (e.g. oxygen-containing hydrocarbon compound such as an alcohol, an ether, an ester, or a carboxylic acid). Other exemplary carbon-containing substances that can be mentioned are paraffin wax, grease, oil, etc.

As already mentioned above, if a substrate is made of a material that would form pyrolytic carbon on its surface in a reducing/inert atmosphere (e.g. due to the presence of carbon-atom containing compounds on the substrate surface), thermal pre-treatment of said substrate in the chemical deposition chamber to which a gaseous or supercritical oxidant is fed, thereby maintaining an oxidizing atmosphere in the chemical deposition chamber during the thermal pre-treatment, successfully prevents the formation of carbon deposits. However, the quality of the graphene grown in a subsequent chemical deposition step is not only improved for those substrates that would form pyrolytic carbon but also for those substrates that would not form pyrolytic carbon.

As indicated above, the process of the present invention comprises a step (ii) wherein the substrate is subjected to a thermal pre-treatment while feeding at least one gaseous or supercritical oxidant into the chemical deposition chamber so as to bring the surface S1 into contact with the at least one gaseous or supercritical oxidant and obtain a pre-treated surface S2.

The thermal pre-treatment step (ii) preferably includes heating the substrate at a temperature which is at least T1, while feeding the one or more gaseous or supercritical oxidants into the chemical deposition chamber. Different heating programs can be used for heating the substrate at the temperature T1. Just as an example, the substrate can be heated at a constant heating rate until the temperature T1 is reached. The temperature T1 may then be kept constant during the entire pre-treatment step (ii) or may be kept constant just for a while before being changed (either increased or decreased) again. Alternatively, the substrate can be heated in a first step to a temperature which is below T1, followed by keeping the temperature constant for a while, and heating up to the final temperature T1. Other heating programs can be used as well.

The substrate can be heated directly or indirectly. Just as an example, heating the substrate can be achieved by heating the chemical deposition chamber to an appropriate temperature (e.g. T1).

The time period for which the substrate is subjected to a thermal pre-treatment (ii) (preferably at a temperature which is at least T1) may vary over a broad range. Preferably, the substrate is subjected to a thermal pre-treatment (ii) for at least 15 minutes, more preferably at least 60 minutes, or at least 270 minutes, or even at least 24 hours.

The temperature T1 can vary over a broad range. T1 can be e.g. at least 450°C, more preferably at least 525°C, even more preferably at least 550°C or at least 700°C. The upper limit should be chosen such that melting or decomposition of the substrate is avoided (e.g. by selecting an upper limit for T1 which is 10°C or even 20°C below the melting temperature of the substrate). Appropriate temperature ranges can easily be adjusted by the skilled person. Exemplary temperature ranges are from 500°C to 2500°C, more preferably from 525°C to 1500°C, even more preferably from 550°C to 1300°C or 700°C to 1300°C or 700°C to 1075°C.

The temperature in the chemical deposition chamber can be measured and controlled by means which are commonly known to the skilled person as for example thermocouples. Appropriate heating elements for chemical deposition chambers are known to the skilled person. Direct or indirect heating elements can be used.

The pressure adjusted in the chemical deposition chamber during the thermal pre-treatment step (ii) may vary over a broad range. The pressure in the chemical deposition chamber during the thermal pre-treatment can be e.g. within the range of from 10⁻¹⁰ hPa to 500000 hPa, more preferably from 10⁻⁹ hPa to 3000 hPa or from 10⁻⁴ hPa to 2000 hPa or from 10⁻³ hPa to 1500 hPa.

The term "chemical deposition chamber" refers to any chamber which is appropriate for carrying out a chemical deposition process. A preferred chemical deposition process used in step (iii) of the present invention is chemical vapour deposition (CVD). So, in a preferred embodiment, the chemical deposition chamber is a chemical vapour deposition (CVD) chamber. Such CVD chambers are commonly known. Just as an example, the CVD chamber can be a hot wall reactor. However, other CVD chambers can be used as well. Other chemical deposition chambers such as autoclaves can be used as well for growing graphene on the substrate by chemical deposition.

As mentioned above, the at least one oxidant coming into contact with the surface S1 of the substrate is in a gaseous or supercritical state. The terms "gaseous" and "supercritical" relate to the temperature and pressure conditions in the chemical deposition chamber during the pre-treatment step (ii). As known to the skilled person, a compound is in a supercritical state at a temperature and a pressure above its critical point.

Preferably, the oxidant is selected from carbon oxides (in particular CO₂ and CO), nitrogen-containing oxides (in particular NO, NO₂, N₂O), H₂O, and O₂, and any mixture thereof. More preferably, the at least one oxidant is CO₂ or CO or a mixture thereof, possibly in combination with one or more of the other oxidants mentioned above.

Feeding the oxidant into the chemical deposition chamber can be accomplished by means commonly known to the skilled person. Preferably, the oxidant is stored in a container which is outside the chemical deposition chamber and is then fed from this external container into the chemical deposition chamber. In principle, the oxidant may already be in a gaseous or supercritical state when stored in an external container. Alternatively, it is possible that the oxidant becomes gaseous or supercritical when entering the chemical deposition chamber (thereby being subjected to the temperature and pressure conditions inside the chemical deposition chamber).

Preferably, the oxidant is continuously fed into the chemical deposition chamber during the thermal pre-treatment step (ii). So, in a preferred embodiment, there is an oxidant feed into the chemical deposition chamber during the whole thermal pre-treatment step (ii), which in turn makes sure that the surface S1 is continuously in contact with the oxidant throughout the entire pre-treatment step (ii). By maximizing the contact time between the oxidant and the surface S1 during the thermal pre-treatment (ii), the risk of generating detrimental carbon deposits on the substrate surface is minimized. However, in principle, it is also possible that the oxidant is only temporarily fed into the chemical deposition chamber, e.g. by a single feed or several feeds over a period of time which is less than the entire time period of the thermal pre-treatment step (ii).

During the thermal pre-treatment step (ii), other gaseous or supercritical compounds which are not an oxidant can be fed into the chemical deposition chamber as well. As exemplary compounds, hydrogen and a compound for heteroatom(e.g. nitrogen- or boron-)doping of graphene can be mentioned.

In a preferred embodiment, no hydrogen is fed into the chemical deposition chamber during the thermal pre-treatment step (ii).

As the thermal pre-treatment step (ii) represents a substrate pre-treatment in preparation of the actual chemical deposition step, no chemical deposition precursor compound is preferably fed into the chamber during step (ii). As will be described below in further detail, such precursor compounds are fed into the chemical deposition chamber in step (iii). So, preferably no hydrocarbon compound is fed into the chemical deposition chamber during step (ii). In other words, no graphene is preferably prepared on the substrate during step (ii).

The amount of the one or more gaseous or supercritical oxidants fed into the chemical deposition chamber during the thermal pre-treatment step (ii) may vary over a broad range. Typically, the amount of the one or more oxidants fed into the chemical deposition chamber during the thermal pre-treatment step (ii) is at least 1 vol%, more preferably at least 5 vol%, even more preferably at least 10 vol% or at least 20 vol%, based on the total amount of gaseous or supercritical compounds fed into the chemical deposition chamber during the thermal pre-treatment step (ii).

It is also possible to use the one or more oxidants in an amount of 100 vol%. So, in a preferred embodiment, only the one or more oxidants (such as CO₂ or CO) but no other compounds are fed into the chemical deposition chamber during the thermal treatment step (ii).

The flow rate at which the at least one oxidant is fed into the chemical deposition chamber during the thermal pre-treatment step (ii) may vary over a broad range. Appropriate flow rates can easily be adjusted by the skilled person. The flow rate at which the at least one oxidant is fed into the chemical deposition chamber during the thermal pre-treatment step (ii) can be e.g. from 0.0001 sccm to 10,000 sccm, more preferably from 0.001 sccm to 2000 sccm, or from 0.01 to 1500 sccm. The flow rate at which the oxidant is fed into the chemical deposition chamber during step (ii) can be kept constant or may vary as a function of time.

As indicated above, the process of the present invention comprises a step (iii) wherein graphene is prepared on the pre-treated surface S2 by chemical deposition.

In the process of the present invention, the at least one gaseous or supercritical oxidant of pre-treatment step (ii) can be completely removed from the chemical deposition chamber before starting the chemical deposition of graphene in step (iii). In principle, it is possible that a further substrate pre-treatment step is carried out in between steps (ii) and (iii). It is also possible that step (iii) is started by introducing the chemical deposition precursor compound (such as a hydrocarbon compound) while the at least one oxidant is still present in the chemical deposition chamber. As will be discussed in further detail below, the presence of an oxidant in step (iii) may even improve graphene quality.

Preparing graphene by chemical deposition is generally known to the skilled person. In a chemical deposition process, a precursor compound is decomposed and/or reacted on the substrate surface so as to form the desired material (i.e. graphene in the present invention). Appropriate precursor compounds and chemical deposition conditions are commonly known to the skilled person or can be adjusted on the basis of common general knowledge. In a preferred embodiment, the chemical deposition is a chemical vapour deposition (CVD). However, other chemical deposition methods can be used as well.

Appropriate conditions and process parameters for depositing graphene on a substrate by chemical vapour deposition (CVD) are commonly known to the skilled person.

Typically, chemical deposition of graphene comprises contacting the pre-treated surface S2 with a gaseous or supercritical precursor compound (in the following also referred to as "chemical deposition precursor compound") which is fed into the chemical deposition chamber. Appropriate precursor compounds which decompose under appropriate conditions and form a graphene layer on the substrate are commonly known to the skilled person.

Preferably, the chemical deposition precursor compound is a hydrocarbon compound, which can be e.g. a saturated or unsaturated or an aromatic hydrocarbon. Optionally, the hydrocarbon compound may contain a functional group. The hydrocarbon compound can be a linear, a branched or a cyclic hydrocarbon compound.

A preferred saturated hydrocarbon that can be used as a chemical deposition precursor compound has the formula CₓH₂ₓ₊₂ with x = 1-8, more preferably x = 1-6, such as methane, ethane, propane or butane.

The unsaturated hydrocarbon precursor compound can be an alkene or an alkyne. A preferred alkene can have the formula CₓH₂ₓ with x = 2 to 6, such as ethylene, propylene, or butylenes. A preferred alkyne is acetylene. As an exemplary aromatic hydrocarbon compound, benzene can be mentioned.

Apart from the chemical deposition precursor compound (which preferably is a hydrocarbon compound), other gaseous compounds can also be fed into the chemical deposition chamber during the chemical deposition step (iii). As exemplary compounds, the following ones can be mentioned: Hydrogen, a compound for heteroatom(e.g. nitrogen- or boron-)doping of graphene such as ammonia or an amine, an oxidant, or any mixture thereof.

As will be discussed below in further detail, a graphene of high quality can still be obtained if no hydrogen is present during the graphene growth step (iii). So, in a preferred embodiment, no hydrogen is fed into the chemical deposition chamber during the chemical deposition of graphene in step (iii), thereby improving process safety management.

In another preferred embodiment, the process of the present invention does not include a step of feeding hydrogen into the chemical deposition chamber. So, in this preferred embodiment, the process of the present invention is a hydrogen-free process.

If an oxidant is present in the chemical deposition chamber during the chemical deposition step (iii), this may further improve graphene quality (as indicated e.g. by a decreased peak width of the G peak in the Raman spectrum measured on the graphene). So, in a preferred embodiment, at least one oxidant is present in the chemical deposition chamber during the chemical deposition of graphene in step (iii). The oxidant can be present for a period of time which is less than the overall time period of the step (iii) (e.g. by using the remaining oxidant of step (ii) or just temporarily feeding the oxidant into the chemical deposition chamber in step (iii)); or may be present during the whole chemical deposition step (iii) (e.g. by continuously feeding an oxidant into the chemical deposition chamber during step (iii)). Preferred oxidants are those that have already been described above for step (ii), i.e. carbon oxides (in particular CO₂ and CO), nitrogen-containing oxides (in particular NO, NO₂, N₂O), H₂O, and O₂, and any mixture thereof. The oxidant may still originate from step (ii), e.g. by starting the chemical deposition step (iii) while the oxidant of the thermal pre-treatment step (ii) is still present in the chemical deposition chamber. It is also possible to feed (either continuously or just temporarily) the oxidant into the chemical deposition chamber during step (iii).

The relative amount of the chemical deposition precursor compound fed into the chemical deposition chamber during step (iii) may vary over a broad range, and may represent e.g. at least 0.1 vol%, more preferably at least 1 vol%, even more preferably at least 10 vol%, or at least 15 vol% or at least 20 vol%, based on the whole amount of gaseous compounds fed into the chemical deposition chamber during the chemical deposition step (iii). In the process of the present invention, it is also possible that only the chemical deposition precursor compound but no other compound is fed into the chemical deposition chamber during step (iii).

The temperature T_{CVD} at which the chemical deposition of the graphene in step (iii) is carried out can vary over a broad range. T_{CVD} can be e.g. at least 450°C, more preferably at least 525°C, even more preferably at least 550°C or at least 700°C. The upper limit should be chosen such that melting or decomposition of the substrate is avoided (e.g. by selecting an upper limit for T_{CVD} which is 10°C or even 20°C below the melting temperature of the substrate). Appropriate temperature ranges can easily be adjusted by the skilled person. Exemplary temperature ranges are from 500°C to 2500°C, more preferably from 525°C to 1500°C, even more preferably from 550°C to 1300°C or 700°C to 1300°C or 700°C to 1075°C.

As already mentioned above, the temperature in the chemical deposition chamber can be measured and controlled by means which are commonly known to the skilled person. Appropriate heating elements for chemical deposition chambers are known to the skilled person. Furthermore, it is generally known to the skilled person how a chemical deposition chamber is to be designed for preparing graphene by chemical deposition.

The pressure adjusted in the chemical deposition chamber during the chemical deposition step (iii) may vary over a broad range. The pressure in the chemical deposition chamber during the thermal pre-treatment can be e.g. within the range of from 10⁻¹⁰ hPa to 500000 hPa, more preferably from 10⁻⁹ hPa to 3000 hPa or from 10⁻⁴ hPa to 2000 hPa or from 10⁻³ to 1500 hPa.

When growth of the graphene in step (iii) is completed, the chemical deposition chamber may then be cooled down (e.g. to room temperature).

Optionally, the process may comprise a further step (iv) wherein the graphene is transferred from the substrate to another substrate different from the substrate on which chemical deposition took place (e.g. a substrate which is more consistent with the intended final use of the CVD-grown graphene.)

According to a further aspect, the present invention relates to the use of a gaseous or supercritical oxidant for the pre-treatment of a substrate in a chemical deposition chamber.

With regard to preferred oxidants and substrates and preferred pre-treatment conditions, reference is made to the statements provided above when discussing the pre-treatment step (ii).

As mentioned above, some substrates used for chemical deposition (e.g. CVD) may include carbon-atom containing impurities and form carbon deposits on their surfaces if subjected to a thermal treatment in a hydrogen atmosphere. So, in a preferred embodiment, the pre-treatment includes cleaning of the substrate.

According to a further aspect, the present invention relates to the graphene obtainable by the chemical deposition process as described above.

The graphene obtainable by the process of the present invention can be used in the manufacturing of electronic, optical, or optoelectronic devices. Exemplary devices that can be mentioned are the following ones: Capacitors, energy-storing devices (such as supercapacitors, batteries and fuel cells), field effect transistors, organic photovoltaic devices, organic light-emitting diodes, photodetectors, electrochemical sensors.

So, according to a further aspect, the present invention relates to a device comprising the graphene obtainable by the chemical deposition process as described above. The device is preferably an electronic, optical, or optoelectronic device, e.g. one of those already mentioned above.

The present invention will now be described in further detail by the following Examples.

### Examples

In the following Examples, a CVD chamber comprising a tube furnace (10 cm tube diameter) made from quartz glass was used.

Gas flows were controlled by mass flow controllers.

Pressure was measured via a Pfeiffer vacuum Pirani gauge.

Raman maps were carried out with a NT-MDT NTEGRA spectrometer. Samples were measured in either a combined AFM-Raman measuring configuration or with a Raman only configuration. Both configurations use a 100x optical objective with an average spot size of around 1µm. The laser wavelength used in all measurements is 514 nm. The diffraction grating used had 600 lines/cm and has a spectral resolution of 1cm⁻¹ at this excitation wavelength. During all measurements there was no observation of the Raman laser altering the sample composition (observed by monitoring the spectra from a single point repeatedly over time during the focusing process). Fits to the G band were carried out using a standard Lorentzian line shape. Typically 3 Raman maps of 20 X 20 data points over a 20µm X 20µm area were carried out on each sample and the G band width from all these scans grouped into histogram bins and the mean value (µ) and standard deviation (σ) extracted from a normal distribution fit to this data. Data from spectra where the fit process fails are filtered from the histograms and mean value calculations but quoted on the shown distributions. These 'fails' can be used to give an order of merit to the consistency of the graphene films.

Scanning electron microscopy (SEM) was performed with a Zeiss LEO 1530.

### Example 1

Two copper foils (in the following referred to as foils "Type B1" and "Type B2") were provided which, according to the product specifications, both had the same purity (99.8% on metals basis) and the same thickness (0.025 mm).

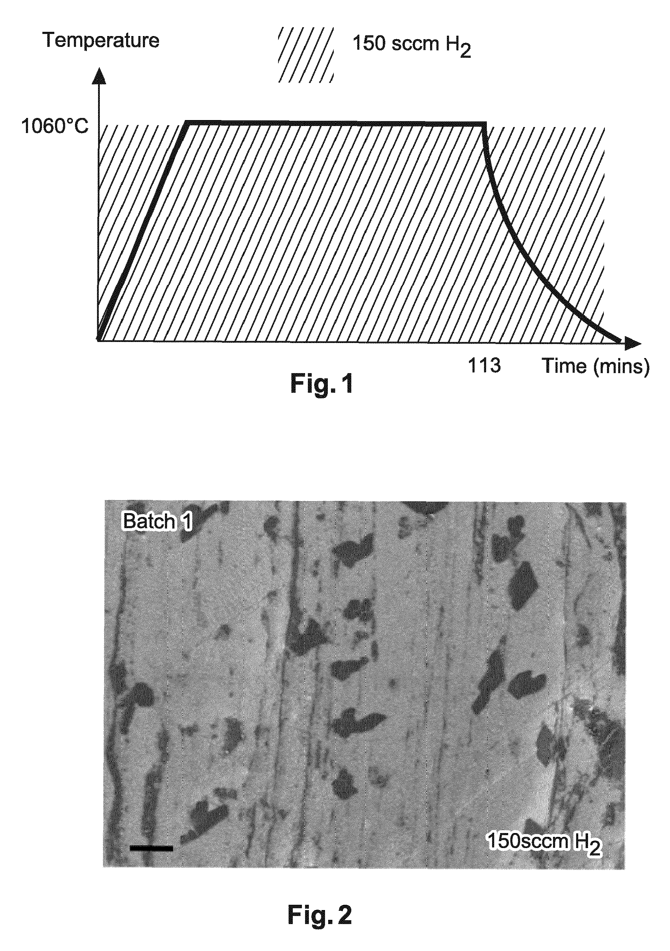

Both metal foils were subjected to a heat treatment in a hydrogen atmosphere, following a thermal treatment scheme as typically used in a CVD process for preparing graphene. The temperature profile is shown in Figure 1. The copper foils were positioned in a CVD chamber, hydrogen was fed into the CVD chamber at 150 sccm while heating the substrate to a temperature of 1060°C for 113 minutes. Hydrogen pressure was about 0.46 mbar.

Figure 2 shows a SEM image of copper foil Type B1 after the thermal treatment in hydrogen. During the thermal treatment, graphitic domains in between areas of disordered carbon were formed on the surface of copper foil Type B1, as can be seen from the SEM image.

Figure 3 shows a SEM image of copper foil Type B2 after the thermal treatment in hydrogen. In contrast to copper foil Type B1, no carbon deposits can be seen on the SEM image.

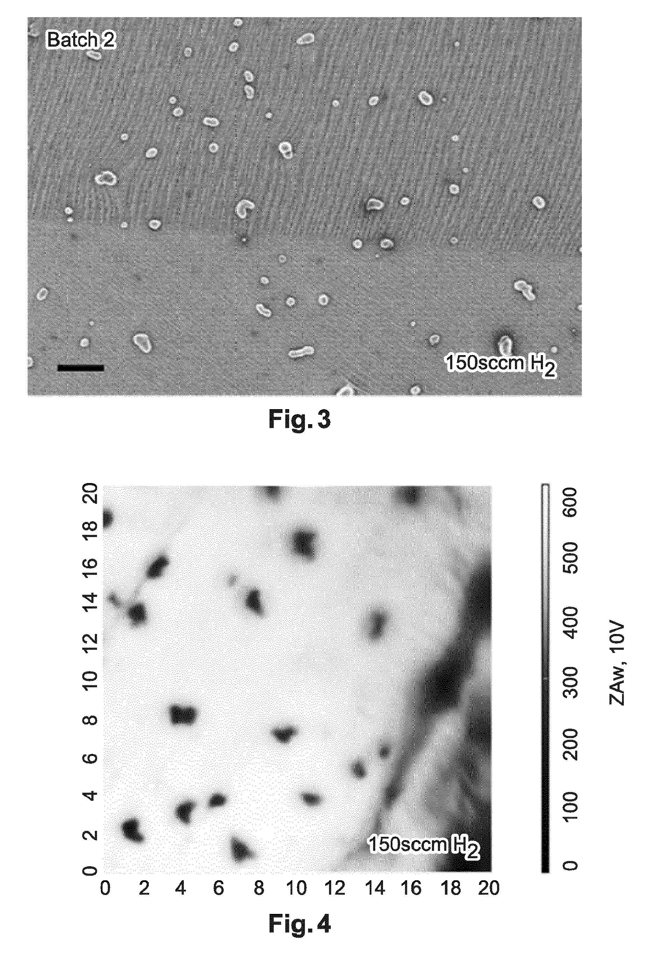

After thermal treatment in hydrogen, the copper foil Type B1 was subjected to a CVD step using methane as a precursor compound in combination with hydrogen (150 sccm hydrogen : 50 sccm methane, temperature used for the CVD: 1060°C, pressure in the CVD chamber: about 0.7 mbar). As can be seen from the optical micrograph image (generated by measuring laser light reflection) shown in Figure 4, the non-graphene carbon deposits are still present on the substrate surface, thereby preventing the formation of well-structured graphene over a wide substrate area.

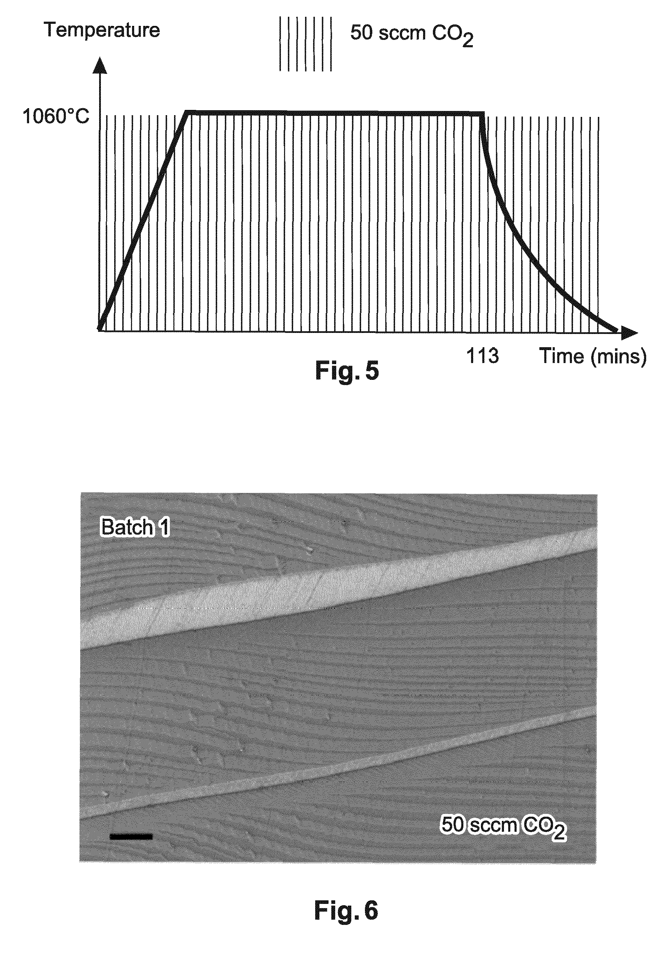

A further copper foil of Type B1 was subjected to a thermal treatment at 1060°C in a CVD chamber while introducing CO₂ at 50 sccm (pressure in CVD chamber: about 0.15 mbar). The temperature profile is shown in Figure 5. A SEM image of the substrate surface thermally treated in the presence of a CO₂ atmosphere is shown in Figure 6. As can be seen from the SEM image shown in Figure 6, no carbon deposits are present on the substrate surface.

Thus, by the Examples described above, it was demonstrated that
- CVD substrates, although being made of the same metal and having the same metal purity, may behave quite differently in a thermal treatment under a hydrogen atmosphere, one substrate forming carbon deposits on its surface while the other substrate does not form such carbon deposits;
- the presence of such carbon deposits may have a detrimental effect on graphene subsequently grown in a CVD step; and
- thermally pre-treating such a substrate in a continuous feed of a gaseous oxidant successfully prevents the formation of carbon deposits on the substrate surface, thereby providing a clean substrate surface for the following CVD step.

### Example 2

Each of the copper foils of Type B1 and Type B2 were subjected to three different thermal pretreatments by feeding the following gaseous compounds into the CVD chamber:
(i) 150 sccm hydrogen (CVD chamber pressure: about 0.46 mbar), or
(ii) 150 sccm hydrogen : 50 sccm CO₂ (CVD chamber pressure: about 0.63 mbar); or
(iii) 50 sccm CO₂ (CVD chamber pressure: about 0.16 mbar);
followed by a CVD step using methane as a precursor compound in combination with hydrogen (150 sccm hydrogen : 50 sccm methane; pressure in CVD chamber: about 0.7 mbar).

In each of these experiments, the substrate was heated to 1060°C for 113 minutes, CVD was carried at 1060°C for 60 minutes.

Raman spectra were measured on the graphene films prepared on the substrates and G band width was determined for each sample. The narrower the G band width, the lower are the number of defects which are present in the graphene material.

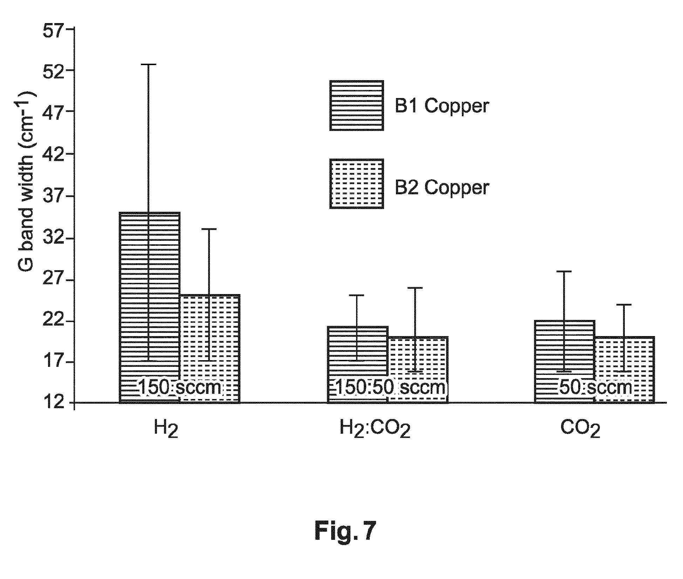

G band width as a function of substrate type and the treatment atmosphere prior to the CVD step is shown in Figure 7.

As can be seen from Figure 7, both the substrate of Type B1 and the substrate of Type B2 shows a significantly decreased G band width when a gaseous oxidant is fed into the CVD chamber during the thermal pre-treatment.

### Example 3

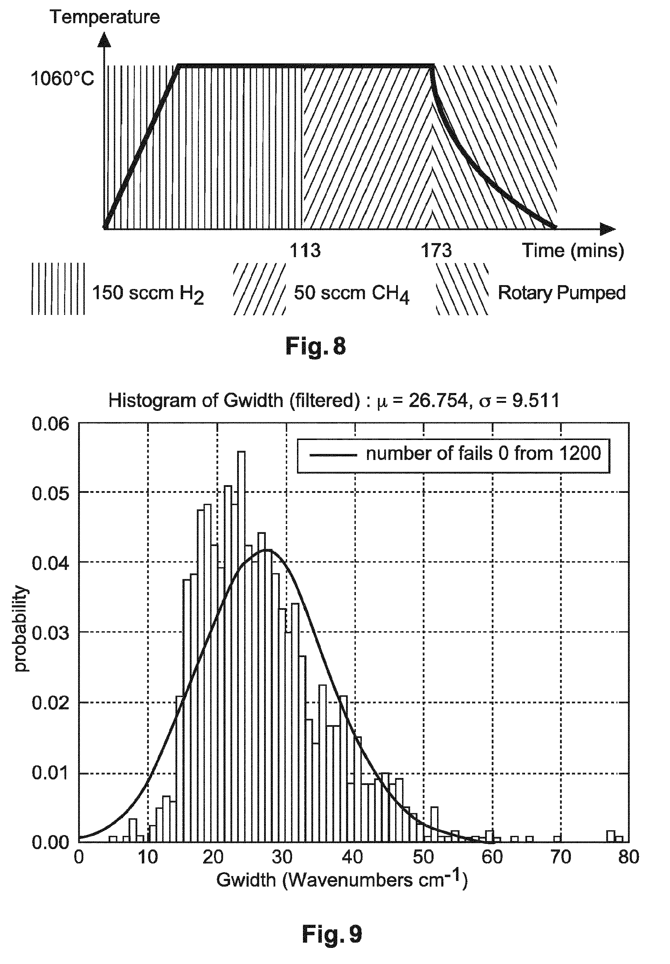

In Example 3.1, the substrate was subjected to a thermal pre-treatment in a hydrogen atmosphere (hydrogen feed at 150 sccm, 113 minutes, heating the substrate to 1060°C, pressure in CVD chamber: about 0.46 mbar). For the CVD step, only methane (50 sccm) but no hydrogen was fed into the CVD chamber. CVD was carried out at 1060°C for 60 minutes, pressure: about 0.2 mbar. The temperature profile is shown in Figure 8. The graphene G band width is shown in Figure 9.

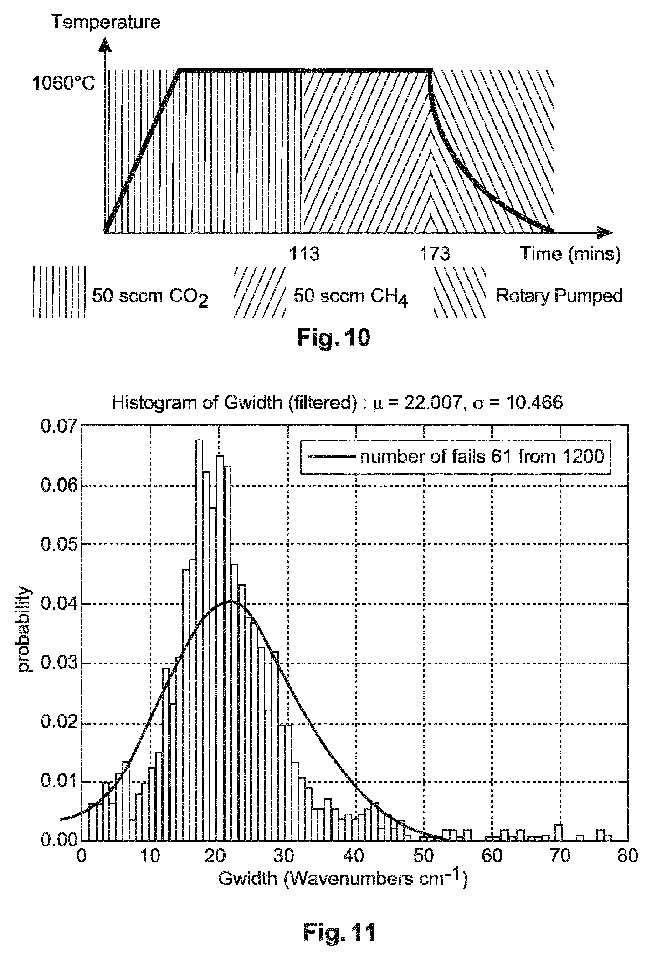

In Example 3.2, the substrate was subjected to a thermal pre-treatment in a hydrogen-free CO₂ atmosphere (CO₂ feed at 50 sccm, 113 minutes, heating the substrate to 1060°C, pressure in CVD chamber: about 0.16 mbar). For the CVD step, only methane (50 sccm) but no hydrogen was fed into the CVD chamber. CVD was carried out at 1060°C for 60 minutes, pressure: about 0.2 mbar. The temperature profile is shown in Figure 10. The graphene G band width is shown in Figure 11.

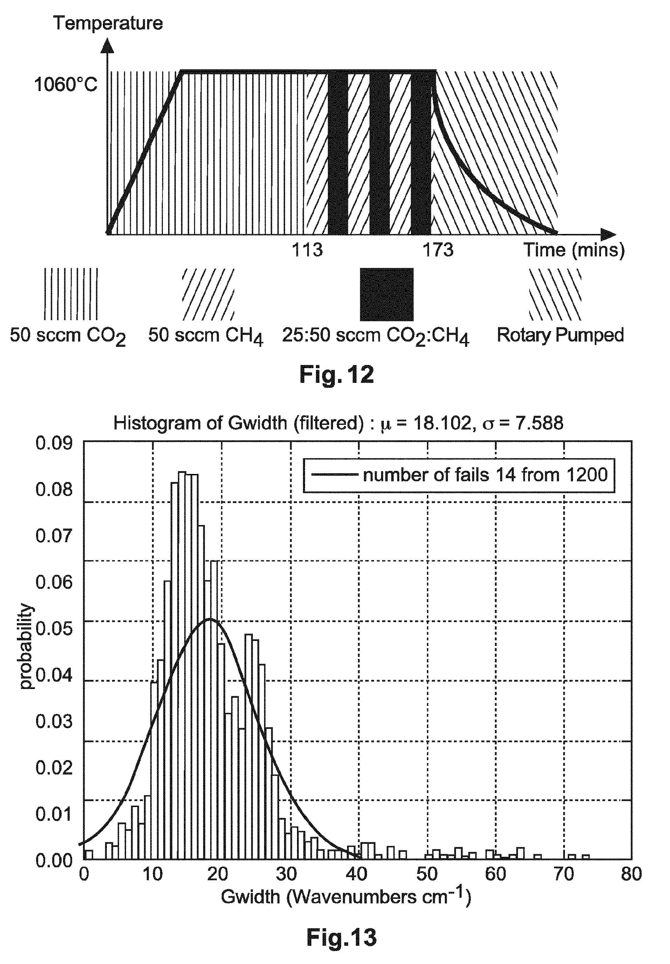

In Example 3.3, the substrate was subjected to a thermal pre-treatment in a hydrogen-free CO₂ atmosphere (CO₂ feed at 50 sccm, 113 minutes, heating the substrate to 1060°C, pressure in CVD chamber: about 0.16 mbar). For the CVD step, alternating feeds of methane (at 50 sccm) and CO₂/methane (25 sccm CO₂ and 50 sccm methane) were introduced into the CVD chamber. CVD was carried out at 1060°C for 60 minutes, pressure: about 0.2-0.3 mbar. The temperature profile is shown in Figure 12. The graphene G band width is shown in Figure 13.

As demonstrated by Examples 3.1 to 3.3,
- high quality graphene is obtainable in a hydrogen-free CVD process,
- an improvement of graphene quality is achieved if the substrate is thermally pre-treated in the presence of a gaseous oxidant, followed by a hydrogen-free CVD step, and
- graphene quality can be even further improved if an oxidant is at least temporarily present in the CVD step (in a hydrogen-free CVD atmosphere).

## Claims

1. A process for preparing graphene, comprising
(i) providing in a chemical deposition chamber a substrate which has a surface S1,
(ii) subjecting the substrate to a thermal pre-treatment while feeding at least one gaseous or supercritical oxidant into the chemical deposition chamber so as to bring the surface S1 into contact with the at least one gaseous or supercritical oxidant and obtain a pre-treated surface S2,
(iii) preparing graphene on the pre-treated surface S2 by chemical deposition.

2. The process according to claim 1, wherein the substrate is selected from a metal, an intermetallic compound, a semiconductor, an inorganic oxide, a metal oxide, a metal nitride or any combination or mixture thereof.

3. The process according to claim 2, wherein the metal is not an alloy.

4. The process according to one of the preceding claims, wherein the substrate is a substrate which forms carbon on its surface S1 if subjected to a thermal treatment in a hydrogen atmosphere; and/or wherein the substrate has one or more carbon-atom-containing compounds on its surface S1.

5. The process according to one of the preceding claims, wherein the chemical deposition chamber is a chemical vapour deposition (CVD) chamber or an autoclave.

6. The process according to one of the preceding claims, wherein the thermal pre-treatment in step (ii) comprises heating the substrate at a temperature of at least 450°C; and/or wherein the pressure in the chemical deposition chamber during the step (ii) is within the range of from 10⁻¹⁰ hPa to 500000hPa.

7. The process according to one of the preceding claims, wherein the oxidant is selected from CO₂, CO, NO, NO₂, N₂O, H₂O, O₂, or any mixture thereof.

8. The process according to one of the preceding claims, wherein the oxidant is fed into the chemical deposition chamber during the whole thermal pre-treatment step (ii); and/or wherein no hydrogen is fed into the chemical deposition chamber during the thermal pre-treatment step (ii).

9. The process according to one of the preceding claims, wherein the chemical deposition of graphene is started while at least some amount of the oxidant of step (ii) is still present in the chemical deposition chamber.

10. The process according to one of the preceding claims, wherein the chemical deposition in step (iii) is a chemical vapour deposition (CVD).

11. The process according to one of the preceding claims, wherein the chemical deposition of graphene comprises contacting the pre-treated surface S2 with a gaseous precursor compound which preferably is a saturated or unsaturated or aromatic hydrocarbon compound.

12. The process according to one of the preceding claims, wherein no hydrogen is fed into the chemical deposition chamber during the chemical deposition of graphene in step (iii); and/or at least one oxidant is present in the chemical deposition chamber during the chemical deposition of graphene in step (iii).

13. The process according to claim 12, wherein the oxidant is selected from CO₂, CO, NO, NO₂, N₂OH₂O, O₂, or any mixture thereof; the oxidant preferably being the same as used in the thermal pre-treatment step (ii).

14. The process according to one of the preceding claims, wherein the graphene prepared on the pre-treated surface S2 is transferred to another substrate.

15. A graphene obtainable by the process according to one of the claims 1 to 14.

16. A device, comprising the graphene according to claim 15.

17. Use of a gaseous or supercritical oxidant for a thermal pre-treatment of a substrate in a chemical deposition chamber.

18. The use according to claim 17, wherein the oxidant is an oxidant according to claim 7;
and/or the substrate is a substrate according to one of the claims 2 to 4; and/or the thermal pre-treatment is a thermal pre-treatment according to one of the claims 1 to 14; and/or the thermal pre-treatment includes a cleaning of the substrate.
